# EUROPÄISCHE PATENTSCHRIFT

(11) **EP 1 502 336 B1**
(45) Veröffentlichungstag und Bekanntmachung des Hinweises auf die Patenterteilung: **08.09.2010**
(21) Anmeldenummer: 03747398.0
(22) Anmeldetag: 05.05.2003
(51) Int. Cl.: H01S 5/026, H01S 5/183, H01S 5/04

(54) **OPTISCH GEPUMPTE HALBLEITERLASERVORRICHTUNG**
OPTICALLY PUMPED SEMICONDUCTOR LASER DEVICE
DISPOSITIF LASER A SEMI-CONDUCTEUR A POMPAGE OPTIQUE

(30) Priorität: 03.05.2002 DE 10219907
(43) Veröffentlichungstag der Anmeldung: 02.02.2005
(73) Patentinhaber: OSRAM Opto Semiconductors GmbH, 93055 Regensburg (DE)
(72) Erfinder: LUTGEN, Stephan, 93047 Regensburg (DE)
(74) Vertreter: Epping - Hermann - Fischer
(86) Internationale Anmeldenummer: PCT/DE2003/001426
(87) Internationale Veröffentlichungsnummer: WO 2003/094311

(56) Entgegenhaltungen:
- EP-A- 0 999 621
- EP-A- 1 130 713
- WO-A-01/93386
- GERHOLD M D ET AL: "NOVEL DESIGN OF A HYBRID-CAVITY SURFACE-EMITTING LASER" IEEE JOURNAL OF QUANTUM ELECTRONICS, IEEE INC. NEW YORK, US, Bd. 34, Nr. 3, 1. März 1998 (1998-03-01), Seiten 506-510, XP000742645 ISSN: 0018-9197
- PATENT ABSTRACTS OF JAPAN Bd. 1996, Nr. 01, 31. Januar 1996 (1996-01-31) & JP 7 249824 A (HITACHI LTD), 26. September 1995 (1995-09-26)

## Beschreibung

Die Erfindung bezieht sich auf eine optisch gepumpte Halbleiterlaservorrichtung nach dem Oberbegriff des Patentanspruchs 1.

Derartige Laservorrichtungen sind beispielsweise aus den Druckschriften WO 01/93386 und WO 02/067393 bekannt, deren Inhalt durch Referenz in die vorliegende Beschreibung aufgenommen wird. Hierin ist eine oberflächenemittierende Halbleiterlaservorrichtung beschrieben, die eine lateral optisch gepumpte Quantentopfstruktur beinhaltet. Als Pumpstrahlungsquelle für diese Quantentopfstruktur dient beispielsweise ein kantenemittierender Halbleiterlaser. Die Pumpstrahlung wird innerhalb der Pumpstrahlungsquelle in einem Wellenleiter geführt. Die Pumpstrahlungsquelle und die Quantentopfstruktur sind jeweils mittels einer Halbleiterschichtenfolge gebildet, wobei die Halbleiterschichtenfolgen auf einem gemeinsamen Substrat epitaktisch aufgewachsen sind. Dies ermöglicht eine kostengünstige monolithische Integration von Quantentopfstruktur und Pumpstrahlungsquelle.

Eine Steigerung der optischen Ausgangsleistung kann prinzipiell dadurch erreicht werden, daß das optisch gepumpte Volumen vergrößert wird. Hierzu ist es wünschenswert, den lateralen Durchmesser der optisch gepumpten Struktur zu erhöhen, wobei bevorzugt ein Grundmodenbetrieb möglich sein bzw. erhalten bleiben soll.

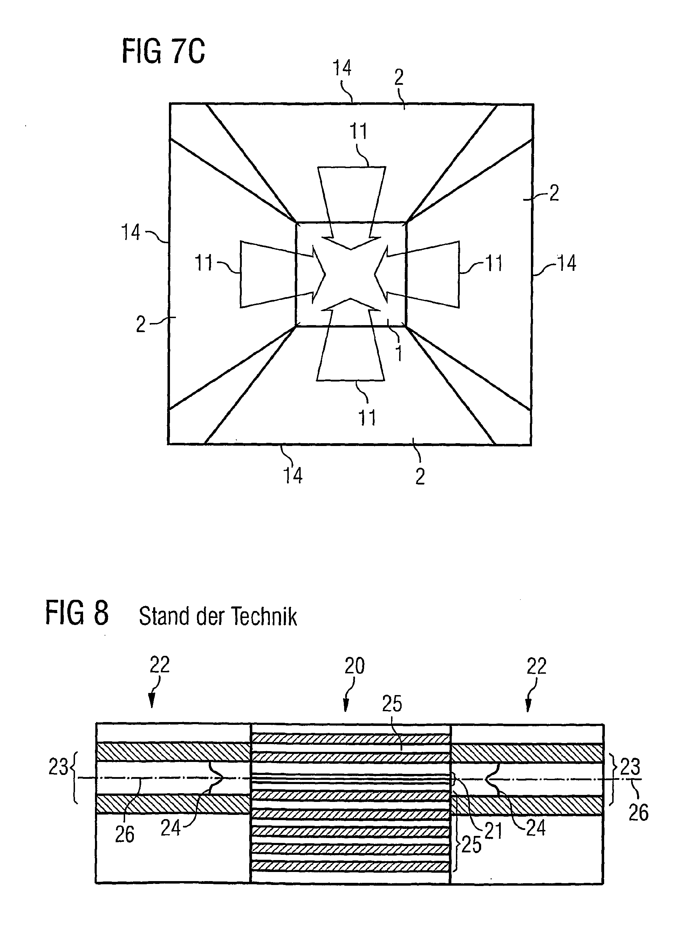

Jedoch führt eine bloße Vergrößerung des lateralen Durchmessers zu Problemen, die im folgenden anhand von Figur 8 erläutert werden:
Figur 8 zeigt eine optisch gepumpte Halbleiterlaservorrichtung mit einem Vertikalemitter 20, der eine strahlungserzeugende Struktur mit einer Mehrzahl von Quantenschichten 21 aufweist. Die strahlungserzeugende Struktur kann zur Bildung eines vertikalen Leserresonators ein- oder beidseitig von Spiegeln 25 umgeben sein. Lateral angrenzend sind zwei Pumplaser 22 zur Erzeugung der Pumpstrahlung angeordnet. Die Pumplaser 22 weisen jeweils einen Wellenleiter 23 auf, in dem die Pumpstrahlung geführt wird.

Bei bekannten Vorrichtungen dieser Art sind diese Wellenleiter in gleicher Höhe wie die Quantenschichten 21 angeordnet, um eine effiziente Einkopplung der Pumpstrahlung in die strahlungserzeugende Struktur zu erzielen. Insbesondere sind die Quantenschichten 21 mittig auf den Pumpwellenleiter 23 ausgerichtet und möglichst nahe an dessen Mittelachse 26 gebildet, so daß das räumliche Maximum des Pumpfeldes 24 mit den Quantenschichten des Vertikalemitters genau überlappt. Dies erfordert eine sehr präzise Fertigung.

Bei einer Vergrößerung des lateralen Durchmessers des Vertikalemitters zeigt sich, daß damit allein oder in Verbindung mit einer höheren Pumpleistung nur eine sehr begrenzte Steigerung der optischen Ausgangsleistung möglich ist. Dies ist dadurch bedingt, daß die Quantenschichten die Pumpstrahlung stark absorbieren, wenn die Pumpstrahlung genau auf die Quantenschichten gerichtet ist. Die Pumpstrahlung wird daher vor allem in der Nähe der Grenzfläche zwischen Pumplaser und Vertikalemitter absorbiert, so daß sich eine kurze laterale Eindringtiefe ergibt. Jenseits dieser lateralen Eindringtiefe wird der Vertikalemitter kaum mehr gepumpt. Damit wird nur am Rand des Vertikalemitter ein Laserbetrieb in einem vergleichsweise kleinen Bereich, der typischerweise schmaler als 30µm ist, erzielt.

Eine Vergrößerung des lateralen Durchmessers bzw. eine Erhöhung der Pumpleistung ändert die Eindringtiefe nicht, so daß damit die optische Ausgangsleistung nur noch geringfügig erhöht wird. Insbesondere wird so eine Steigerung der Ausgangsleistung aufgrund einer Vergrößerung des gepumpten aktiven Bereichs nicht erreicht.

Hinzu kommt, daß ein Pumpen der Quantenschichten in der Nähe der Grenzfläche zwischen Pumplaser und Vertikalemitter mit zusätzlichen Verlusten verbunden ist, da die bei dem Pumpprozeß erzeugten Ladungsträger innerhalb einer Diffusionslänge von etwa 10µm zur Grenzfläche diffundieren und dort aufgrund von Grenzflächendefekten nichtstrahlend rekombinieren können. Auch aus diesem Grund ist es wünschenswert, den lateralen Durchmesser des Vertikalemitters zu vergrößern, um so die Quantenschichten in einem möglichst großen Abstand von dieser Grenzfläche zu pumpen. Wiederum genügt aber eine bloße Vergrößerung des lateralen Durchmessers nicht, da dies die randnahe Absorption innerhalb einer vergleichweise kurzen Eindringtiefe nicht ändert.

Es ist Aufgabe der vorliegenden Erfindung, eine optisch gepumpte Halbleitervorrichtung mit hoher Ausgangsleistung zu schaffen. Insbesondere soll die Erfindung eine laterale Vergrößerung des optisch gepumpten Bereichs ermöglichen.

Diese Aufgabe wird mit einer optisch gepumpten Halbleitervorrichtung gemäß Patentanspruch 1 gelöst. Vorteilhafte Weiterbildungen der Erfindung sind Gegenstand der abhängigen Ansprüche.

Erfindungsgemäß ist vorgesehen, eine optisch gepumpte Halbleiterlaservorrichtung mit einem Vertikalemitter, der einen Zentralwellenleiter und innerhalb des Zentralwellenleiters eine Quantentopfstruktur mit mindestens einer Quantenschichten aufweist, und einer Pumpstrahlungsquelle, die die Quantentopfstruktur lateral optisch pumpt und die mindestens einen Pumpwellenleiter, in dem die Pumpstrahlung geführt wird, umfaßt, zu bilden, wobei die Breite des Zentralwellenleiters des Vertikalemitters größer als die Breite des Pumpwellenleiters ist, und diese Breiten derart aneinander angepaßt sind, daß die Quantentopfstruktur des Vertikalemitters gleichförmig gepumpt wird.

Bezüglich des Vertikalemitters ist hierbei die Bezeichnung "Zentralwellenleiter" nicht als Ortsangabe im Sinne einer zwangsläufig mittigen Anordnung, sondern lediglich als Unterscheidung zum Pumpwellenleiter zu verstehen.

Die Breite des Pump- bzw. des Zentralwellenleiters ist jeweils senkrecht zur Propagationsrichtung gemessen.

Unter einem gleichförmigen Pumpen ist im Rahmen der Erfindung insbesondere eine Anregung der Quantentopfstruktur zu verstehen, bei der kein Anregungsminimum im Zentrum des Vertikalemitters entsteht oder bei der zumindest auch im Zentrum des Vertikalemitters eine Strahlungserzeugung stattfindet. Vorteilhaft ist hier eine Anregung mit einem Anregungsmaximum im Zentrum des Vertikalemitters, vorzugsweise derart, daß ein Grundmodenbetrieb des Vertikalemitters, z.B. im TEM₀₀-Mode, möglich ist. Besonders bevorzugt ist eine großflächige Anregung mit einem Durchmesser des Vertikalemitters größer oder gleich 20µm. Weiterhin entspricht im Rahmen der Erfindung die Erzeugung eines zumindest näherungsweise gaußförmigen, hypergäußförmigen oder rechteckförmigen Anregungsprofils einem gleichförmigen Pumpen, wobei wiederum ein großflächiges Anregungsprofil bevorzugt ist.

Bei einer vorteilhaften Ausführungsform der Erfindung sind die Quantenschichten beabstandet von einer in Propagationsrichtung der Pumpstrahlung verlaufenden Mittelachse des Pumpwellenleiters angeordnet. Dies bewirkt im Gegensatz zu der in Figur 8 gezeigten Anordnungen, daß die Pumpstrahlung versetzt zu den Quantenschichten des Vertikalemitters in den Zentralwellenleiter eingekoppelt wird. Hierbei ist es vorteilhaft, die Quantenschichten des Vertikalemitters so anzuordnen, daß deren Abstand zur Mittelachse des Pumpwellenleiters größer ist als der Strahlradius des Pumpstrahlungsfeldes beim Eintritt in den Vertikalemitter. Dies kann zum Beispiel mittels eines Pumpwellenleiters realisiert werden, dessen halbe Breite kleiner ist als der Abstand der Quantenschicht des Vertikalemitters zur Mittelachse des Pumpwellenleiters.

Überraschenderweise hat sich im Rahmen der Erfindung gezeigt, daß bei einem großen lateralen Durchmesser des Vertikalemitters insgesamt so ein größerer Überlapp der Pumpstrahlung mit den Quantenschichten im Zentrum des Vertikalemitters und damit ein großflächigerer und effizienterer Betrieb mit höherer Ausgangsleistung ermöglicht wird. Dies steht im Gegensatz zu der herkömmlichen Annahme, eine mittige Anordnung der Quantentopfstruktur zum Pumpwellenleiter sei für eine effiziente Einkopplung optimal. Diese Annahme gilt demnach nur für kleine laterale Durchmesser.

Es sei angemerkt, daß unter dem genannten Abstand ein vorgegebener und wohldefinierter Abstand der Quantenschicht von der Mittelachse zu verstehen ist. Zwar kann auch bei der in Figur 8 gezeigten Vorrichtung ein Abstand zwischen Quantenschicht und der entsprechenden Mittelachse auftreten, der beispielsweise dadurch bedingt sein kann, daß bei mehreren Quantenschichten zwangsläufig nicht alle Quantenschichten mit der Mittelachse zusammenfallen können oder daß ein solcher Abstand innerhalb der Fertigungstoleranz liegt. Hierbei handelt es sich im Gegensatz zu der Erfindung aber nicht um einen vorgegebenen und wohldefinierten Abstand.

Weiterhin ist es in diesem Zusammenhang vorteilhaft, die Breite des Pumpwellenleiters und die Breite des Zentralwellenleiters so aneinander anzupassen, daß sich die Pumpstrahlung nach dem Eintritt in den Vertikalemitter aufweitet. Damit wird erreicht, daß die Pumpstrahlung in einem vorgegebenen Abstand vom Eintritt der Pumpstrahlung in den Vertikalemitter mit den Quantenschichten überlappt. Eine Anregung der Quantenschichten in der Nähe der Grenzfläche zwischen Pumpstrahlungsquelle und Vertikalemitter und die damit einhergehenden Verluste durch nichtstrahlende Rekombination können so deutlich reduziert werden.

Im Rahmen der Erfindung können Pumpwellenleiter und Zentralwellenleiter symmetrisch oder asymmetrisch zueinander angeordnet sein. Bei einer asymmetrischen Anordnung fallen die Mittelachse des Pumpwellenleiters und eine Mittelachse des Zentralwellenleiters nicht zusammen und sind vorzugsweise parallel zueinander angeordnet. Eine asymmetrische Anordnung kann hinsichtlich der epitaktischen Herstellung des Vertikalemitters bzw. der Halbleiterlaservorrichtung vorteilhaft sein.

Die Erfindung eignet sich besonders für Halbleiterlaservorrichtungen hoher optischer Ausgangsleistung, zum Beispiel größer oder gleich 0,1W, vorzugsweise größer oder gleich 1,0W oder sogar größer oder gleich 10W. Die Pumpstrahlungsquelle ist hierzu bevorzugt als Pumplaser ausgeführt. Um die für eine hohe Ausgangsleistung erforderliche Pumpleistung zu erzeugen, umfaßt die Pumpstrahlungsquelle vorzugsweise eine Mehrzahl von Pumplasern. Diese können so angeordnet sein, daß jeweils zwei Pumplaser von entgegengesetzten Seiten in den Vertikalemitter einstrahlen. Weitergehend ist eine kreuz- oder sternförmige Positionierung der Pumplaser um den Vertikalemitter herum zweckmäßig.

Weitere Merkmale, Vorzüge und Zweckmäßigkeiten der Erfindung ergeben sich aus der nachfolgenden Beschreibung von sechs Ausführungsbeispielen in Verbindung mit den Figuren 1 bis 7.

Es zeigen:
- Figur 1: eine schematische Schnittansicht eines ersten Ausführungsbeispiels einer erfindungsgemäßen Halbleiterlaservorrichtung,
- Figur 2: eine graphische Darstellung der Strahlaufweitung der Pumpstrahlung in dem Zentralwellenleiter längs der Ausbreitungsrichtung der Pumpstrahlung,
- Figur 3: eine graphische Darstellung des Überlapps von Pumpstrahlung und Quantenschicht längs Ausbreitungsrichtung der Pumpstrahlung,
- Figur 4A und 4B: eine schematische Schnittansicht und eine zugehörige Aufsicht eines zweiten Ausführungsbeispiels einer erfindungsgemäßen Halbleiterlaservorrichtung,
- Figur 5: eine graphische Darstellung eines dreidimensionalen Absorptionsprofils bei dem zweiten Ausführungsbeispiel einer erfindungsgemäßen Halbleiterlaservorrichtung,
- Figur 6: eine schematische Schnittansicht eines dritten Ausführungsbeispiels einer erfindungsgemäßen Halbleiterlaservorrichtung,
- Figur 7A, 7B, 7C: jeweils eine schematische Aufsicht eines vierten, fünften und sechsten Ausführungsbeispiels einer erfindungsgemäßen Halbleiterlaservorrichtung, und
- Figur 8: eine schematische Schnittansicht einer entsprechenden Halbleiterlaservorrichtung mit herkömmlicher Pumpanordnung.

Gleiche oder gleich wirkende Elemente sind in den Figuren mit denselben Bezugszeichen versehen.

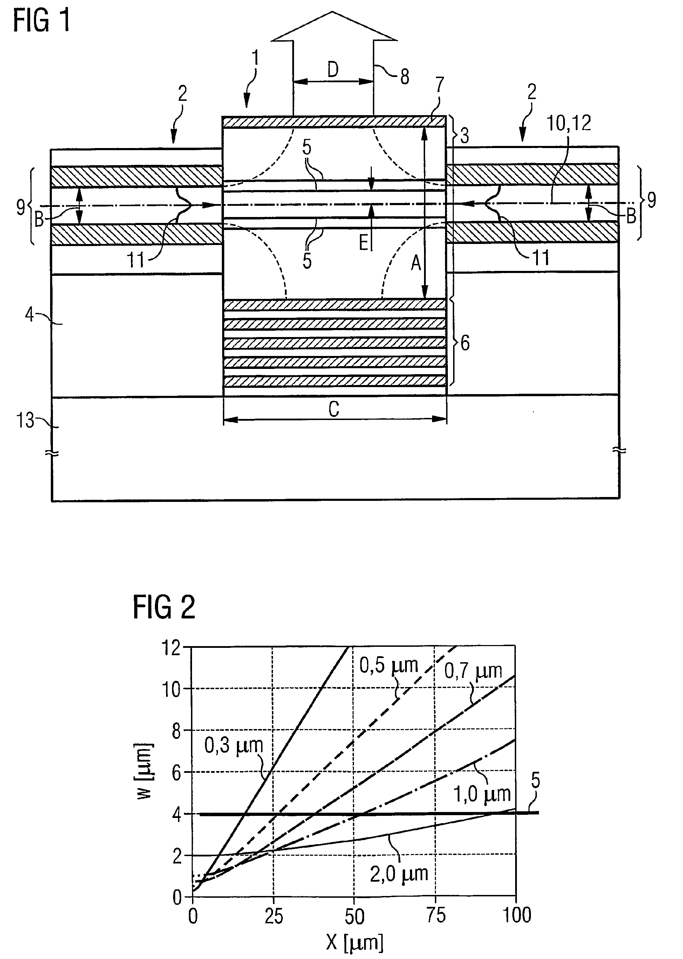

Die in Figur 1 dargestellte Halbleiterlaservorrichtung umfaßt einen Vertikalemitter 1 und eine Pumpstrahlungsquelle in Form zweier Pumplaser 2.

Der Vertikalemitter 1 weist einen Zentralwellenleiter 3 sowie eine innerhalb des Zentralwellenleiters 3 angeordnete strahlungserzeugende Quantentopfstruktur mit einer Mehrzahl von Quantenschichten 5 auf. In vertikaler Richtung ist dem Zentralwellenleiter ein Spiegel 6 nachgeordnet. Vorzugsweise ist dieser Spiegel als Bragg-Spiegel mit einer Mehrzahl alternierender Schichten mit unterschiedlichem Brechungsindex ausgeführt. Dem Spiegel gegenüberliegend ist oberseitig auf den Zentralwellenleiter 3 eine Auskoppelschicht 7 aufgebracht, durch die die von dem Vertikalemitter erzeugte Strahlung 8 ausgekoppelt wird.

Der Spiegel 6 kann mit einem externen Spiegel (nicht dargestellt) einen externen Laserresonator für den Vertikalemitter bilden. Eine derartige Vorrichtung wird auch als VECSEL (Vertical External Cavity Surface Emitting Laser) bezeichnet. Alternativ kann zur Ausbildung eines internen Resonators nach Art eines VCSEL (Vertical Cavity Surface Emitting Laser) zwischen Auskoppelschicht 7 und Zentralwellenleiter 3 ein teildurchlässiger Auskoppelspiegel, vorzugsweise ein Bragg-Spiegel, angeordnet sein.

Weitergehend kann in einem externen Laserresonator ein nichtlineares optisches Element, beispielsweise ein nichtlinearer Kristall, zur Frequenzkonversion angeordnet sein. Diese Ausführung ist für eine Frequenzkonversion, insbesondere eine Frequenzvervielfachung wie etwa eine Frequenzverdopplung der von der Quantentopfstruktur erzeugten Strahlung 8 vorteilhaft. Ebenso kann diese Ausführung der Erfindung für andere nichtlineare Konversionen wie beispielsweise Summenfrequenzerzeugung, Differenzfrequenzerzeugung, Erzeugung von Subharmonischen, Raman-Streuung oder Vierwellenmischen herangezogen werden, wobei optional das von dem Vertikalemitter generierte Strahlungsfeld mit einem weiteren, zum Beispiel extern erzeugten Strahlungsfeld in dem nichtlinearen optischen Element überlagert wird.

Bei einer weiteren Ausführungsform der Erfindung ist in dem externen Laserresonator ein Element zur Modenkopplung, vorzugsweise zur passiven Modenkopplung wie etwa KLM (Kerr Lens Modelocking), vorgesehen. Hierfür ist beispielsweise ein sättigbarer Halbleiterabsorber (z.B. ein SESAM, Semiconductor Saturable Absorber Mirror) geeignet. Durch die Modenkopplung wird ein gepulster Betrieb des mit dem Vertikalemitter gebildeten Lasers ermöglicht. Hiermit können Impulsdauern bis in den Pikosekunden- oder sogar Femtosekundenbereich erzielt werden.

Für einen Betrieb im Femtosekundenbereich ist in der Regel eine Kompensation der Gruppengeschwindigkeitsdispersion in dem externen Resonator erforderlich, da ansonsten die Gruppengeschwindigkeitsdispersion zur einer zeitlichen Verbreiterung der erzeugten Impulse führt. Eine Kompensation der Gruppengeschwindigkeitsdispersion ist beispielsweise mittels Prismen, Gittern oder optischen Fasern möglich und wird beispielsweise bei bekannten fs-Titan-Saphir-Lasern eingesetzt.

Bevorzugt wird die Gruppengeschwindigkeitsdispersion bei der Erfindung mittels sogenannter "gechirpter Spiegel" kompensiert. Diese Spiegel weisen eine Mehrzahl von Materialschichten auf, die derart an die Gruppengeschwindigkeitsverhältnisse des externen Resonators angepaßt sind, daß insgesamt die Gruppengeschwindigkeitsdispersion kompensiert wird. Bei der Erfindung kann der obengenannte externe Spiegel oder ein zusätzlicher Resonatorspiegel, etwa bei einem gefalteten externen Resonator, als gechirpter Spiegel ausgeführt sein.

Die lateral angeordneten beiden Pumplaser 2 umfassen jeweils eine aktive Schicht sowie einen Pumpwellenleiter 9 mit einer Mittelachse 10, in dem die Pumpstrahlung 11 geführt wird. Wie in Figur 1 angedeutet weist die Pumpstrahlung 11 ein näherungsweise gaußförmiges Profil auf. Weiterhin kann eine Pufferschicht 4 vorgesehen sein, um die Pumpwellenleiter in vertikaler Richtung in geeigneter Höhe in Bezug auf den Zentralwellenleiter zu positionieren.

Die Quantenschichten 5 sind in einem vorgegebenen Abstand von der Mittelachse 10 angeordnet, wobei die der Mittelachse 10 am nächsten liegende Quantenschicht bzw. Quantenschichten 5 zur Mittelachse einen Abstand E aufweisen.

Vorzugsweise sind Pumplaser und Vertikalemitter monolithisch integriert, d.h. auf ein gemeinsames Substrat 13 epitaktisch aufgewachsen. Nach der Herstellung kann dieses Substrat 13 abgedünnt oder auch vollständig entfernt werden. Dies ist beispielsweise für eine verbesserte Wärmeabgabe an einen Kühlkörper zweckmäßig.

Bei einer weiteren Alternative der Erfindung ist der Spiegel 6 auf der Oberseite des Zentralwellenleiters aufgebracht. Die Strahlungsauskopplung erfolgt dann auf der dem Spiegel gegenüberliegenden Seite durch das Substrat hindurch. Auch in diesem Fall kann das Substrat abgedünnt oder entfernt sein.

Im Betrieb wird die von den Pumplasern 2 erzeugte Pumpstrahlung lateral in die Quantentopfstruktur eingekoppelt und in den Quantenschichten 5 absorbiert und regt so die Emission der Strahlung 8 an (optisches Pumpen). Bei der Ausgestaltung des Vertikalemitters als Laser dient die Quantentopfstruktur als optisch gepumptes aktives Medium, in dem die Laserstrahlung durch stimulierte Emission generiert bzw. verstärkt wird.

Die Breite A des Zentralwellenleiters 3 ist bei der Erfindung größer als die Breite B des Pumpwellenleiters und ist so an letztere angepaßt, daß die Quantentopfstruktur des Vertikalemitters gleichmäßig und vorzugsweise großflächig gepumpt wird. Im einzelnen wird dies bei dem in Figur 1 gezeigten Ausführungsbeispiel durch eine Strahlaufweitung der Pumpstrahlung sowie eine beabstandete Anordnung der Quantenschichten 5 von der Mittelachse 10 der Pumpwellenleiter 9 erreicht.

Die Strahlaufweitung beruht auf der Beugung des Pumpstrahlungsfeldes 11 nach dem Übergang von dem Pumpwellenleiter 9 in den deutlich breiteren Zentralwellenleiter 3. Die Anzahl der Moden im Zentralwellenleiter ist dabei so groß, daß näherungweise eine freie Propagation der Pumpstrahlung im Zentralwellenleiter angenommen werden kann. Der Verlauf der Pumpstrahlung kann im Rahmen der Gauß'schen Optik ermittelt werden. Die Gauß'sche Optik sowie Definitionen der zugehörigen charakteristischen Parameter sind in A. Yariv, Quantum Electronics, 3rd ed., 1988, John Wiley & Sons beschrieben.

In Figur 2 ist die Strahlaufweitung der Pumpstrahlung beispielhaft für verschiedene Strahlradien der Pumpstrahlung beim Eintritt in den Vertikalemitter dargestellt. Aufgetragen ist in Figur 2 der Strahlradius w eines gaußförmigen Bündels längs der lateralen Propagationsrichtung X für verschiedene Strahlradien (0,3µm; 0,5µm; 0,7µm; 1,0µm; 2,0µm) beim Eintritt in den Vertikalemitter. Der Strahlradius beim Eintritt wird durch den Pumpwellenleiter festgelegt und entspricht der halben Breite B des Pumpwellenleiters. Berechnet wurden die dargestellten Verläufe für eine Pumpwellenlänge von 940nm.

In Figur 2 ist weiterhin die Position einer Quantenschicht 5 mit einem beispielhaften Abstand E von 4µm zur Mittelachse des Pumpwellenleiters eingetragen. Ein Überlapp zwischen Quantenschicht und Pumpstrahlungsfeld ist um so weiter von dem Eintritt des Pumpstrahlungsfelds und damit einer gegebenenfalls zu nichtstrahlenden Verlusten führenden Grenzfläche entfernt, je größer die Breite des Pumpwellenleiters ist. Denn mit steigender Breite verringert sich die Beugung und damit die Stahlaufweitung.

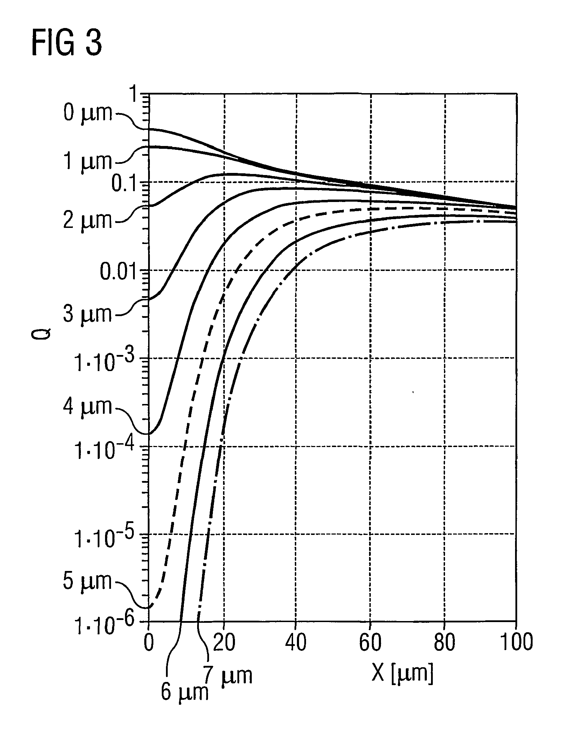

Ein gleichförmiges Pumpen der Quantentopfstruktur kann weiterhin durch eine Optimierung des Abstands E der Quantenschichten von der Mittelachse des Pumpwellenleiters erzielt werden. Dies ist beispielhaft in Figur 3 dargestellt.

In Figur 3 ist logarithmisch der berechnete Überlapp Q (in willkürlichen Einheiten) zwischen dem Pumpfeld und einer Quantenschicht längs der lateralen Propagationsichtung X im Vertikalemitter für verschiedene Abstände E der Quantenschicht von der Mittelachse des Pumpwellenleiters aufgetragen. Für diese Abstände E wurden die Werte 1µm, 2µm, 3µm, 4µm, 5µm, 6µm und 7µm gewählt. Zusätzlich ist auch der Überlapp für eine Quantenschicht am Ort der Mittelachse, d.h. mit einem Abstand von 0µm aufgetragen.

Die oben im Zusammenhang mit Figur 2 genannten Parameter der zugrundeliegenden Halbleiterlaserstruktur wurden unverändert übernommen. Die Breite des Pumpwellenleiters beträgt 1,4µm entsprechend einem Strahlradius von 0,7µm beim Eintritt in den Vertikalemitter.

Der Verlauf des Überlapps Q entspricht im wesentlichen dem lateralen Absorptionsprofil. Wie Figur 3 zeigt, ergibt sich für einen Abstand der Quantenschicht von der Mittelachse kleiner oder gleich 1µm ein Absorptionsmaximum beim Eintritt der Pumpstrahlung in den Vertikalemitter mit einem nachfolgenden näherungsweise exponentiellen Abfall. Dies entspricht herkömmlichen Pumpanordnungen, wie sie beispielhaft in Figur 8 dargestellt sind. Eine laterale Vergrößerung des Vertikalemitters führt hier nur zu einer geringfügigen Erhöhung der optischen Ausgangsleistung, da die Pumpstrahlung im wesentlichen am Rand des Vertikalemitters absorbiert wird, und somit nur dort in einem Bereich, der typischerweise schmäler als 20µm ist, eine kleinflächige Strahlungserzeugung bzw. ein kleinflächiger Laserbetrieb erzielt wird.

Für größere Abstände der Quantenschicht von der Mittelachse verschiebt sich das Absorptionsmaximum zum Zentrum des Vertikalemitters hin. Dabei ist mit wachsendem Abstand das Absorptionsmaximum immer schwächer ausgeprägt, so daß sich ein mehr im Zentrum des Vertikalemitters lokalisiertes Absorptionsprofil und damit eine zunehmend gleichförmige Anregung der Quantenschicht ergibt. Insbesondere wird dabei eine Anregung am Rand des Vertikalemitters vermieden, so daß Verluste aufgrund von nichtstrahlender Rekombination am Rand des Vertikalemitters vorteilhaft verringert werden.

Insgesamt ergibt sich aus den Figuren 2 und 3 in Verbindung mit weiteren Berechnungen, daß für das in Figur 1 gezeigte Ausführungsbeispiel und eine Pumpwellenlänge von 940nm eine Breite B des Pumpwellenleiters größer oder gleich 1µm in Verbindung mit einem Abstand E der Quantenschichten von 4µm oder mehr von der Mittelachse der Pumpwellenleiter vorteilhaft ist. Insbesondere kann so eine gleichförmige und großflächige Anregung der Quantentopfstruktur erzielt werden.

Die Breite A des Zentralwellenleiters liegt bevorzugt in einem Bereich zwischen 5µm und 30µm. Im Hinblick auf die oben genannte Beabstandung der Quantenschicht von der Mittelachse des Pumpwellenleiters ist ein Bereich zwischen 10µm und 30µm besonders bevorzugt.

Die Erfindung eignet sich insbesondere für Vertikalemitter mit einem großen lateralen Durchmesser C zwischen 10µm und 1000µm, der bevorzugt größer oder gleich 100µm ist. Bei dem in Figur 1 gezeigten Ausführungsbeispiel liegt dieser Durchmesser C zwischen 200µm und 300µm und der Strahldurchmesser D zwischen 100µm und 200µm. Ein Durchmesser größer oder gleich 20µm ist zur Vermeidung einer grenzflächennahen nichtstrahlenden Rekombination vorteilhaft, da die Diffusionslänge der Ladungsträger etwa 10µm beträgt. Eine nichtstrahlende Rekombination wird durch Anregung in einem Abstand vom Rand des Vertikalemitters, der größer als diese Diffusionslänge ist, maßgeblich verringert.

Beispielhaft weist der Vertikalemitter bei dem in Figur 1 gezeigten Ausführungsbeispiel vier Quantenschichten auf. Der genannte Abstand bezieht sich dabei auf die der Mittelachse 10 am nächsten liegende Quantenschicht. Selbstverständlich kann im Rahmen der Erfindung auch eine andere Anzahl von Quantenschichten gewählt werden.

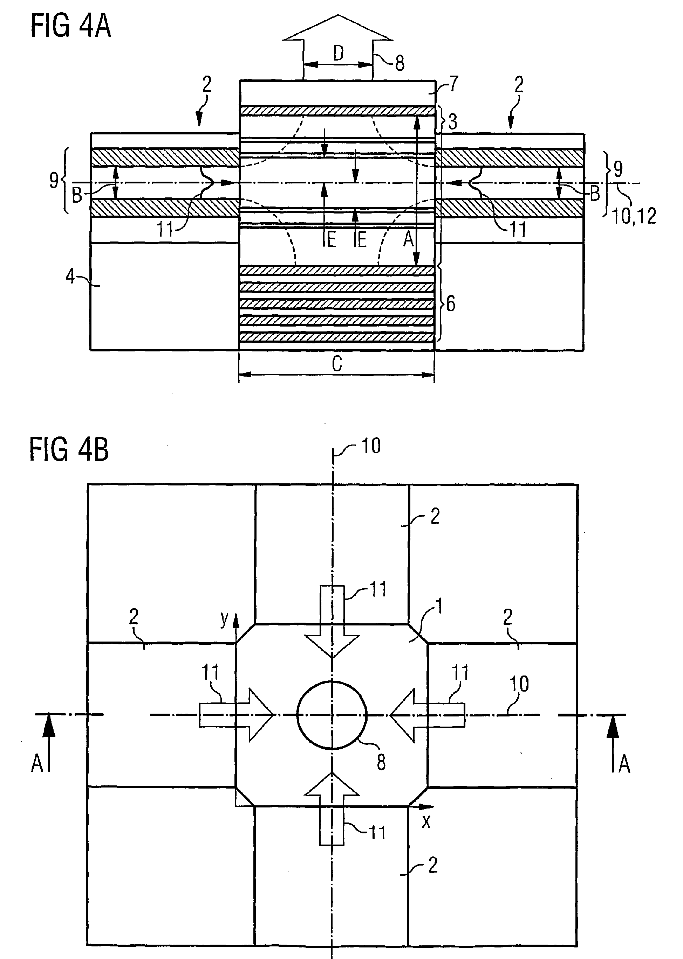

In Figur 4A ist eine Schnittdarstellung eines zweiten Ausführungsbeispiels einer erfindungsgemäßen Halbleiterlaservorrichtung gezeigt, Figur 4B zeigt die zugehörige Aufsicht. Die zu Figur 4A gehörende Schnittebene verläuft längs der Linie A-A in Figur 4B.

Wie bei dem in Figur 1 dargestellten Ausführungsbeispiel umfaßt die Halbleiterlaserstruktur einen Vertikalemitter 1 mit einem Zentralwellenleiter 3, einem dem Zentralwellenleiter vertikal nachgeordneten Spiegel 6 und einer oberseitigen Auskoppelschicht 7. Lateral angrenzend ist die Pumpstrahlungsquelle angeordnet.

Die Pumpstrahlungsquelle umfaßt bei dem in Figur 4 gezeigten Ausführungsbeispiel vier Pumplaser 2, die um den Vertikalemitter 1 herum angeordnet sind. Die Pumplaser 2 sind paarweise orthogonal zueinander positioniert, wobei jeweils zwei Pumplaser 2 von zwei gegenüberliegenden Seiten in den Vertikalemitter 1 einstrahlen. Diese symmetrische Anordnung ist für eine gleichförmige Anregung der Quantentopfstruktur vorteilhaft.

Alternativ kann auch jede andere Anzahl von Pumplasern vorgesehen sein, wobei mehrere Pumplaser vorzugsweise sternförmig um den Vertikalemitter angeordnet sind.

Die Pumplaser 2 weisen wie bei dem in Figur 1 gezeigten Ausführungsbeispiel jeweils einen Pumpwellenleiter 9 mit einer Mittelachse 10 auf. Aufgrund der sternförmig symmetrischen Anordnung fallen die Mittelachsen 10 der jeweils gegenüberliegenden Pumpwellenleiter 9 zusammen und stehen senkrecht auf den Mittelachsen der beiden anderen Pumpwellenleiter.

Innerhalb des Zentralwellenleiters 3 sind vier Quantenschichten 5 ausgebildet. Im Gegensatz zu dem in Figur 1 gezeigten Ausführungsbeispiel sind diese in einem vertikalen Abstand zu den Mittelachsen angeordnet, der größer als die halbe Breite B des Pumpwellenleiters ist. Dies bedeutet, daß das Pumpstrahlungsfeld beim Eintritt in den Vertikalemitter nicht mit den Quantenschichten überlappt (von einem geringfügigen Überlapp aufgrund der theoretisch nicht begrenzten Flanken eines räumlich gaußförmigen Pumpfeldes wird hierbei abgesehen).

Ein Überlapp zwischen dem Pumpstrahlungsfeld 11 und den Quantenschichten 5 tritt erst bei einem vorgegebenen Abstand vom Eintritt des Pumpstrahlungsfeldes 11 in den Vertikalemitter 1 auf. Dieser Abstand ist durch die Strahlaufweitung des Pumpstrahlungsfeldes in Verbindung mit dem Abstand E der Quantenschichten 5 von den Mittelachsen 10 der Pumpwellenleiter 9 festgelegt.

Für eine gleichförmige Anregung eines Vertikalemitters 1 mit einem großen lateralen Durchmesser C zwischen 200µm und300µm und einem Strahldurchmesser D zwischen 100µm und 200µm ist ein Pumpwellenleiter einer Breite zwischen 0,2µm und 2µm in Verbindung mit einem Zentralwellenleiter 3 einer Breite zwischen 2µm und 14µm geeignet. Die Pumpwellenlänge kann beispielsweise 940nm und die Emissionswellenlänge des Vertikalemitters 1000nm betragen.

Vorzugsweise sind die Quantenschichten in einem Abstand zwischen 1µm bis 6µm von den Mittelachsen 10 der Pumpwellenleiter 9 angeordnet. Ein Abstand von 5µm in Verbindung mit einem etwas mehr als 10µm breiten Zentralwellenleiter hat sich als besonders vorteilhaft erwiesen. Die Quantenschichten sind dabei nahe am Rand des Zentralwellenleiters und insbesondere in einem Maximum des sich im Betrieb im Vertikalemitter ausbildenden Strahlungsfeldes von stehenden Wellen angeordnet, bevorzugt in dem dem Rand des Zentralwellenleiters am nächsten liegenden Maximum.

Allgemein ist es im Rahmen der Erfindung zweckmäßig, die Quantenschicht bzw. die Quantenschichten so anzuordnen, daß sie mit einem Maximum, d.h. einem Wellenbauch der sich aus dem von der Quantentopfstruktur des Vertikalemitters generierten Strahlungsfeld bildenden stehenden Welle überlappen.

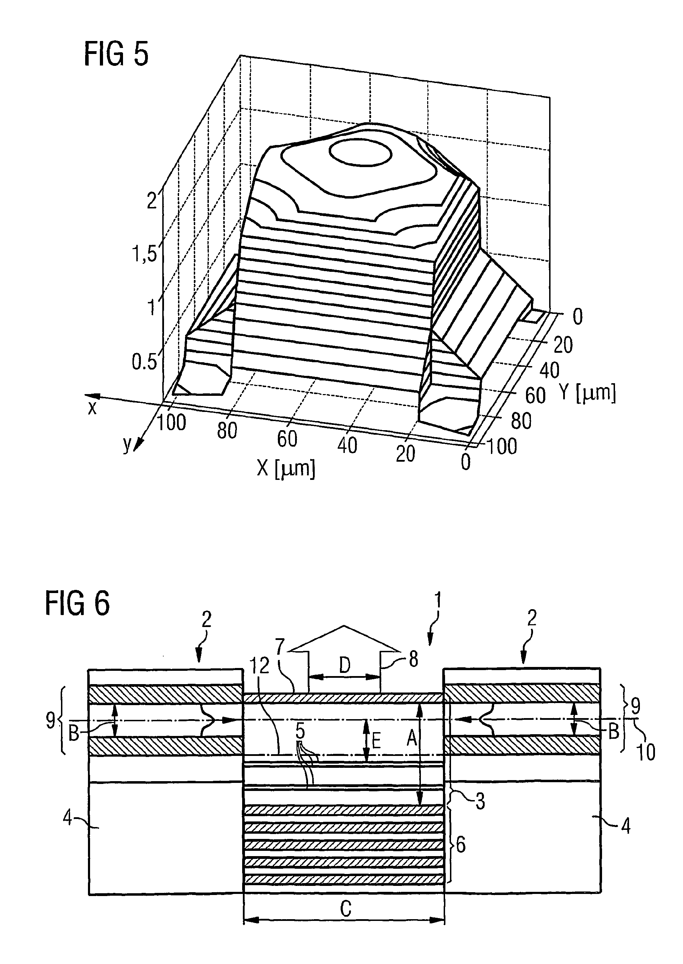

In Figur 5 ist das berechnete Absorptionsprofil für eine Halbleiterlasersvorrichtung gemäß Figur 4 und die obengenannten Parameter dargestellt. Aufgetragen ist die Absorption des Pumpfeldes in willkürlichen Einheiten in Abhängigkeit der lateralen Position, d.h. den Koordinaten X und Y des in Figur 4B angegebenen Koordinatensystems. Es ergibt sich eine vorteilhaft schwach variierende Absorption für die gesamte aktive Fläche des Vertikalemitters mit einem Absorptionsmaximum in der Mitte bzw. dem Symmetriezentrum der Halbleiterlaservorrichtung. Das Absorptionsprofil entspricht näherungsweise einem Hypergaußprofil.

In Figur 6 ist ein Ausführungsbeispiel einer Halbleiterlaseranordung ähnlich dem in Figur 4A gezeigten Ausführungsbeispiel dargestellt.

Im Unterschied zu dem letztgenannten Ausführungsbeispiel ist der Zentralwellenleiter 3 asymmetrisch zu den Pumpwellenleitern 9 positioniert, d.h. eine dem Zentralwellenleiter zugeordnete Mittelachse 12 ist in vertikaler Richtung beabstandet zu den Mittelachsen 10 der Pumpwellenleiter angeordnet.

Weiterhin sind nur auf einer Seite der Mittelachse 12 des Zentralwellenleiters 3 Quantenschichten 5 ausgebildet. Bei dem gezeigten Ausführungsbeispiel sind die Quantenschichten 5 zwischen Mittelachse 12 und Spiegel 6 angeordnet.

Alternativ können sich die Quantenschichten 5 auch auf der anderen Seite der Mittelachse 12, also zwischen Mittelachse 12 und Auskoppelschicht befinden. Beide Ausgestaltungen haben den Vorteil, daß die Quantenschichten in ähnlicher Weise wie bei dem in Figur 4 gezeigten Ausführungsbeispiel von der Mittelachse 10 des Pumpwellenleiters beabstandet sind und zugleich der Zentralwellenleiter 3 mit einer geringeren Breite A ausgeführt werden kann. Dadurch wird die epitaktische Herstellung erleichtert, da allgemein mit steigender Schichtdicke und speziell mit steigender Breite der Wellenleiter die Aufwachszeiten verlängert werden und zudem die Herstellung fehlerfreier Schichten erschwert wird.

Die Breite des Zentralwellenleiters liegt vorzugsweise zwischen 2µm und 7µm, der Abstand der Quantenschichten von der Mittelachse des Pumpwellenleiters beträgt zwischen 1µm und 6µm. Die übrigen Parameter sind wie bei dem in Figur 4 gezeigten Ausführungsbeispiel gewählt.

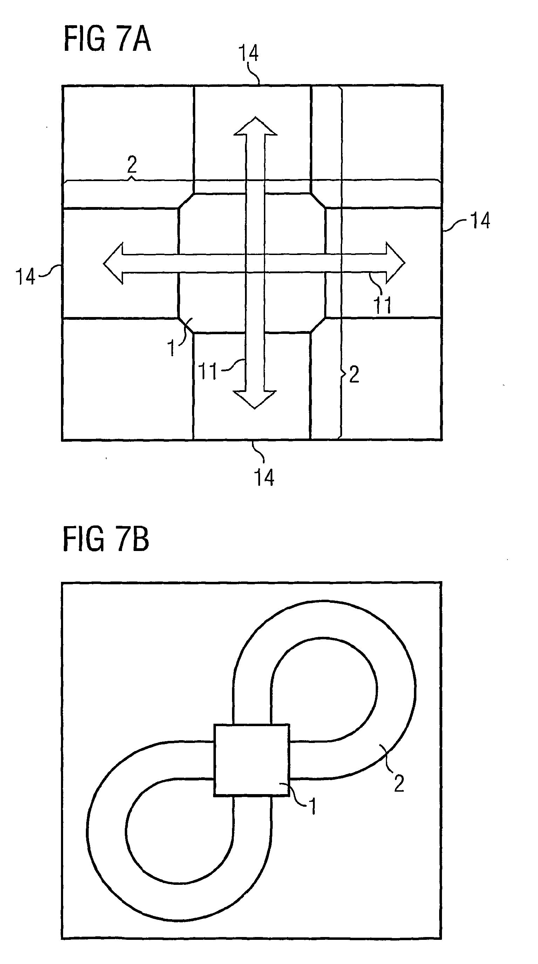

In den Figuren 7A, 7B und 7C sind in der Aufsicht drei weitere Ausführungsbeispiele der Erfindung dargestellt. Diese unterscheiden sich von dem in Figur 4B gezeigten Ausführungsbeispiel in der Anordnung der Pumpstrahlungsquelle.

Bei dem in Figur 7A gezeigten Ausführungsbeispiel bilden die jeweils gegenüberliegenden Bereiche der Pumpstrahlungsquelle gemeinsam einen Pumplaser 2, so daß die Resonatoren dieser Pumplaser 2 sich kreuzen, wobei der Vertikalemitter im Kreuzungsbereich positioniert ist. Der Resonator der Pumplaser wird also jeweils durch die außenliegenden Spiegel oder Facetten 14 begrenzt.

Wesentlich ist bei dieser Ausführungsform der Erfindung, daß der Vertikalemitter 1 zumindest teilweise innerhalb der Resonators eines Pumplasers 2 angeordnet ist. Vorteilhafterweise wird so die Anzahl der für die Pumplaser erforderlichen Spiegel bzw. Facetten reduziert und die Herstellung vereinfacht. Hierbei ist es zweckmäßig, die Grenzfläche zwischen Vertikalemitter und Pumplaserbereich so zu bilden, daß möglichst geringe Reflexionen der Pumpstrahlung, vorzugsweise unter 2%, entstehen. Selbstverständlich können auch nur ein Pumplaser oder mehr als zwei Pumplaser vorgesehen sein.

Bei der in Figur 7B gezeigten Ausführungsform der Erfindung befindet sich der Vertikalemitter ebenfalls zumindest teilweise innerhalb des Pumplaserresonators. Der Pumplaser ist als Ringlaser, d.h. als Laser mit einem Ringresonator ausgebildet. Vorteilhafterweise sind somit keine Resonatorspiegel bzw. -facetten erforderlich. Dies vereinfacht die Herstellung und schließt einen Defekt aufgrund von beschädigten Pumplaserspiegen aus. Der Ringresonator des Pumplasers ist in der Aufsicht 8-förmig, so daß der Vertikalemitter 1 im Kreuzungsbereich an vier Seiten gepumpt wird. Im Rahmen der Erfindung kann aber auch jede andere Form eines Ringresonators vorgesehen sein.

Das in Figur 7C dargestellte Ausführungsbeispiel entspricht im wesentlichen dem in Figur 4B gezeigten Ausführungsbeispiel, wobei die Pumplaser in der Aufsicht trapezförmig geformt sind. Hierdurch wird eine bessere Ausnutzung der Gesamtfläche der Halbleiterlaservorrichtung und damit eine höhere Pumpleistung bei gleicher Gesamtfläche erreicht.

Wie dargestellt können entsprechend dem in Figur 4B gezeigten Ausführungsbeispiel vier kreuzförmig angeordnete Pumplaser vorgesehen sein. Alternativ können entsprechend Figur 7A zwei gegenüberliegende Pumplaserbereiche einen gemeinsamen Pumplaser bilden, wobei der Vertikalemitter 1 wiederum zumindest teilweise innerhalb des Pumplasersresonators bzw. der Pumplaserresonatoren angeordnet ist. Bei der letztgenannten Variante weisen die Pumplaserresonatoren also jeweils einen zweifach trapezförmigen lateralen Querschnitt auf.

Die Erläuterung der Erfindung anhand der Ausführungsbeispiele ist nicht als Beschränkung der Erfindung hierauf zu verstehen. Die Erfindung bezieht sich vielmehr auf sämtliche Vorrichtungen mit den in den Ansprüchen genannten Merkmalen. Weiterhin umfaßt die Erfindung sämtliche in der Beschreibung genannten Merkmale sowie deren Kombinationen, selbst wenn diese nicht in den Ansprüchen oder der Beschreibung explizit genannt sind.

Die in der Beschreibung genannten Bereiche sind jeweils einschließlich der Bereichsgrenzen zu verstehen. Weiterhin stellt jede dieser Bereichsangaben für sich bereits eine vorteilhafte Ausgestaltung der Erfindung dar, die nicht notwendigerweise mit allen anderen Bereichsangaben kombinierbar sein muß. Im Zweifel ist die Breite des Zentralwellenleiters und die Lage der Quantenschichten jeweils so zu wählen, daß die Quantenschichten innerhalb des Zentralwellenleiter angeordnet sind.

## Patentansprüche

1. Optisch gepumpte Halbleiterlaservorrichtung mit
- einem Vertikalemitter (1), der einen Zentralwellenleiter (3) und eine innerhalb des Zentralwellenleiters (3) angeordnete Quantentopfstruktur mit mindestens einer Quantenschicht (5) aufweist, und
- einer Pumpstrahlungsquelle, die die Quantentopfstruktur lateral optisch pumpt und die mindestens einen Pumpwellenleiter (9) umfaßt, in dem die Pumpstrahlung (11) geführt wird,
**dadurch gekennzeichnet, daß** die Breite (A) des Zentralwellenleiters (3) größer als die Breite (B) des Pumpwellenleiters (9) ist, und die Breite (A) des Zentralwellenleiters und die Breite (B) des Pumpwellenleiters (9) derart aneinander angepaßt sind, daß die Quantentopfstruktur des Vertikalemitters (1) gleichförmig gepumpt wird.

2. Halbleiterlaservorrichtung nach Anspruch 1,
**dadurch gekennzeichnet, daß**
der Pumpwellenleiter (9) eine Mittelachse (10) aufweist und die Quantenschicht (5) in einem vorgegebenen Abstand (E) von der Mittelachse (10) des Pumpwellenleiters (9) angeordnet ist.

3. Halbleiterlaservorrichtung nach Anspruch 1 oder 2,
**dadurch gekennzeichnet, daß**
der Zentralwellenleiter (3) eine Mittelachse (12) aufweist, die zu der Mittelachse (10) des Pumpwellenleiters (9) parallel ist oder mit der Mittelachse (10) des Pumpwellenleiters (9) zusammenfällt.

4. Halbleiterlaservorrichtung nach einem der Ansprüche 1 bis 3,
**dadurch gekennzeichnet, daß**
die Quantenschicht (5) einen Abstand (E) von der Mittelachse (10) des Pumpwellenleiters (9) aufweist, der größer ist als der Strahlradius der Pumpstrahlung (11) beim Eintritt in den Vertikalemitter (1).

5. Halbleiterlaservorrichtung nach Anspruch 4,
**dadurch gekennzeichnet, daß**
die Pumpstrahlung (11) innerhalb des Zentralwellenleiters (3) aufgeweitet ist und mit der Quantenschicht (5) in einem vorgegebenen Abstand vom Eintritt der Pumpstrahlung (11) in den Vertikalemitter (1) überlappt.

6. Halbleiterlaservorrichtung nach einem der Ansprüche 1 bis 5,
**dadurch gekennzeichnet, daß**
der Vertikalemitter (1) einen Spiegel (6) umfaßt, der der Quantentopfstruktur in vertikaler Richtung nachgeordnet ist.

7. Halbleiterlaservorrichtung nach Anspruch 6,
**dadurch gekennzeichnet, daß**
die Quantentopfstruktur in vertikaler Richtung zwischen dem Spiegel (6) und einer Auskoppelschicht (7) angeordnet ist.

8. Halbleiterlaservorrichtung nach Anspruch 6 oder 7,
**dadurch gekennzeichnet, daß** dem Vertikalemitter (1) ein externer Spiegel zugeordnet ist, der mit dem Spiegel (6) des Vertikalemitters (1) einen Resonator für die von der Quantentopfstruktur emittierte Strahlung (8) bildet.

9. Halbleiterlaservorrichtung nach Anspruch 8,
**dadurch gekennzeichnet, daß**
innerhalb des Resonators ein nichtlineares optisches Element, vorzugsweise zur Frequenzverdopplung, angeordnet ist.

10. Halbleiterlaservorrichtung nach Anspruch 8 oder 9,
**dadurch gekennzeichnet, daß** innerhalb des Resonators ein Element zur Modenkopplung, insbesondere ein sättigbarer Halbleiterabsorber angeordnet ist.

11. Halbleiterlaservorrichtung nach einem der Ansprüche 8 bis 10,
**dadurch gekennzeichnet, daß**
ein Spiegel des Resonators für die von der Quantentopfstruktur emittierte Strahlung (8), insbesondere der externe Spiegel ein gechirpter Spiegel ist.

12. Halbleiterlaservorrichtung nach einem der Ansprüche 6 bis 11,
**dadurch gekennzeichnet, daß**
der Vertikalemitter (1) einen Auskoppelspiegel umfaßt, durch den die von der Quantentopfstruktur emittierte Strahlung (8) ausgekoppelt wird.

13. Halbleiterlaservorrichtung nach einem der Ansprüche 6 bis 12,
**dadurch gekennzeichnet, daß**
der Spiegel (6) bzw. die Spiegel als Bragg-Spiegel ausgebildet sind.

14. Halbleiterlaservorrichtung nach einem der Ansprüche 1 bis 13,
**dadurch gekennzeichnet, daß**
die Pumpstrahlungsquelle mindestens einen Pumplaser (2) umfaßt.

15. Halbleiterlaservorrichtung nach Anspruch 14,
**dadurch gekennzeichnet, daß**
die Pumpstrahlungsquelle zwei Pumplaser (2) mit jeweils einem Pumpwellenleiter (9) umfaßt, deren Pumpstrahlung (11) in entgegengesetzter Richtung in die Quantentopfstruktur eingekoppelt wird.

16. Halbleiterlaservorrichtung nach Anspruch 14 oder 15,
**dadurch gekennzeichnet, daß**
die Pumpstrahlungsquelle eine Mehrzahl von Pumplasern (2) umfaßt, die kreuz- oder sternförmig um den Vertikalemitter (1) herum angeordnet sind.

17. Halbleiterlaservorrichtung nach Anspruch 16,
**dadurch gekennzeichnet, daß**
die Pumpstrahlungsquelle vier Pumplaser (2) umfaßt, die paarweise orthogonal zueinander angeordnet sind.

18. Halbleiterlaservorrichtung nach einem der Ansprüche Anspruch 14 bis 17,
**dadurch gekennzeichnet, daß**
der Pumplaser (2) einen Pumplaserresonator aufweist und der Vertikalemitter (1) zumindest teilweise innerhalb des Pumplaserresonators angeordnet ist.

19. Halbleiterlaservorrichtung nach einem der Ansprüche Anspruch 14 bis 18,
**dadurch gekennzeichnet, daß**
der Pumplaser als Ringlaser ausgebildet ist.

20. Halbleiterlaservorrichtung nach einem der Ansprüche Anspruch 14 bis 19,
**dadurch gekennzeichnet, daß**
der Pumplaser einen Pumplaserresonator mit einem zumindest teilweise trapezförmigen oder zweifach trapezförmigen lateralen Querschnitt aufweist.

21. Halbleiterlaservorrichtung nach einem der Ansprüche 1 bis 20,
**dadurch gekennzeichnet, daß**
die Pumpstrahlungsquelle und der Vertikalemitter (1) monolithisch integriert ausgebildet sind.

22. Halbleiterlaservorrichtung nach einem der Ansprüche 1 bis 21,
**dadurch gekennzeichnet, daß**
die Halbleiterlaservorrichtung ein Halbleiterscheibenlaser ist.

23. Halbleiterlaservorrichtung nach einem der Ansprüche 1 bis 22,
**dadurch gekennzeichnet, daß**
die Halbleiterlaservorrichtung für einen gepulsten Betrieb, insbesondere mit einer Impulsdauer im Pikosekunden- oder Femtosekundenbereich ausgebildet ist.

24. Halbleiterlaservorrichtung nach einem der Ansprüche 1 bis 23,
**dadurch gekennzeichnet, daß**
im Betrieb im Vertikalemitter (1) die Quantentopfstruktur ein Strahlungsfeld erzeugt, das eine stehende Welle bildet, wobei die Quantenschicht (5) so angeordnet ist, daß sie mit einem Wellenbauch der stehenden Welle überlappt.

## Claims

1. Optically pumped semiconductor laser apparatus having
- a vertical emitter (1) which has a central waveguide (3) and a quantum well structure which is arranged within the central waveguide (3) and has at least one quantum layer (5), and
- a pump radiation source, which optically pumps the quantum well structure in a lateral direction and comprises the at least one pump waveguide (9) in which the pump radiation (11) is guided,
**characterized in that**
the width (A) of the central waveguide (3) is greater than the width (B) of the pump waveguide (9), and the width (A) of the central waveguide and the width (B) of the pump waveguide (9) are matched to one another such that the quantum well structure of the vertical emitter (1) is pumped uniformly.

2. Semiconductor laser apparatus according to Claim 1,
**characterized in that**
the pump waveguide (9) has a centre axis (10), and the quantum layer (5) is arranged at a predetermined distance (E) from the centre axis (10) of the pump waveguide (9).

3. Semiconductor laser apparatus according to Claim 1 or 2,
**characterized in that**
the central waveguide (3) has a centre axis (12) which is parallel to the centre axis (10) of the pump waveguide (9), or coincides with the centre axis (10) of the pump waveguide (9).

4. Semiconductor laser apparatus according to one of Claims 1 to 3,
**characterized in that**
the quantum layer (5) is at a distance (E) from the centre axis (10) of the pump waveguide (9), which distance (E) is greater than the beam radius of the pump radiation (11) when it enters the vertical emitter (1).

5. Semiconductor laser apparatus according to Claim 4,
**characterized in that**
the pump radiation (11) is widened within the central waveguide (3), and overlaps the quantum layer (5) at a predetermined distance from the point at which the pump radiation (11) enters the vertical emitter (1).

6. Semiconductor laser apparatus according to one of Claims 1 to 5,
**characterized in that**
the vertical emitter (1) has a mirror (6), which is arranged downstream from the quantum well structure in the vertical direction.

7. Semiconductor laser apparatus according to Claim 6,
**characterized in that**
the quantum well structure is arranged in the vertical direction between the mirror (6) and an output layer (7).

8. Semiconductor laser apparatus according to Claim 6 or 7,
**characterized in that**
the vertical emitter (1) has an associated external mirror which, together with the mirror (6) of the vertical emitter (1), forms a resonator for the radiation (8) which is emitted from the quantum well structure.

9. Semiconductor laser apparatus according to Claim 8,
**characterized in that**
a non-linear optical element, preferably for frequency doubling, is arranged within the resonator.

10. Semiconductor laser apparatus according to Claim 8 or 9,
**characterized in that**
an element for mode coupling, in particular a saturable semiconductor absorber, is arranged within the resonator.

11. Semiconductor laser apparatus according to one of Claims 8 to 10,
**characterized in that**
one mirror of the resonator for the radiation (8) which is emitted from the quantum well structure, in particular the external mirror, is a chirped mirror.

12. Semiconductor laser apparatus according to one of Claims 6 to 11,
**characterized in that**
the vertical emitter (1) has an output mirror, by means of which the radiation (8) which is emitted from the quantum well structure is emitted.

13. Semiconductor laser apparatus according to one of Claims 6 to 12,
**characterized in that**
the mirror (6) or the mirrors is or are in the form of a Bragg mirror or mirrors.

14. Semiconductor laser apparatus according to one of Claims 1 to 13,
**characterized in that**
the pump radiation source has at least one pump laser (2).

15. Semiconductor laser apparatus according to Claim 14,
**characterized in that**
the pump radiation source has two pump lasers (2) each having one pump waveguide (9), whose pump radiation (11) is injected into the quantum well structure in the opposite direction.

16. Semiconductor laser apparatus according to Claim 14 or 15,
**characterized in that**
the pump radiation source has two or more pump lasers (2), which are arranged in a cruciform shape or star shape around the vertical emitter (1).

17. Semiconductor laser apparatus according to Claim 16,
**characterized in that**
the pump radiation source has four pump lasers (2), which are arranged in pairs at right angles to one another.

18. Semiconductor laser apparatus according to one of Claims 14 to 17,
**characterized in that**
the pump laser (2) has a pump laser resonator, and the vertical emitter (1) is arranged at least partially within the pump laser resonator.

19. Semiconductor laser apparatus according to one of Claims 14 to 18,
**characterized in that**
the pump laser is a ring laser.

20. Semiconductor laser apparatus according to one of Claims 14 to 19,
**characterized in that**
the pump laser has a pump laser resonator with an at least partially trapezoidal or double trapezoidal lateral cross section.

21. Semiconductor laser apparatus according to one of Claims 1 to 20,
**characterized in that**
the pump radiation source and the vertical emitter (1) are monolithically integrated.

22. Semiconductor laser apparatus according to one of Claims 1 to 21,
**characterized in that**
the semiconductor laser apparatus is a semiconductor disk laser.

23. Semiconductor laser apparatus according to one of Claims 1 to 22,
**characterized in that**
the semiconductor laser apparatus is designed for pulsed operation, in particular with a pulse duration in the picosecond or femtosecond range.

24. Semiconductor laser apparatus according to one of Claims 1 to 23,
**characterized in that,**
during operation, the quantum well structure produces a radiation field in the vertical emitter (1), which radiation field forms a standing wave, with the quantum layer (5) being arranged such that it overlaps an antinode of the standing wave.

## Revendications

1. Dispositif laser à semiconducteur à pompage optique comprenant
- un émetteur vertical (1) qui présente un guide d'onde central (3) et une structure en pot quantique disposée à l'intérieur du guide d'onde central (3) et comprenant au moins une couche quantique (5), et
- une source de rayonnement de pompage qui réalise le pompage optique latéral de la structure en pot quantique et qui comprend au moins un guide d'onde de pompage (9) dans lequel est guidé le rayonnement de pompage (11),
**caractérisé en ce que** la largeur (A) du guide d'onde central (3) est supérieure à la largeur (B) du guide d'onde de pompage (9) et la largeur (A) du guide d'onde central ainsi que la largeur (B) du guide d'onde de pompage (9) sont adaptées l'une à l'autre de telle sorte que la structure en pot quantique de l'émetteur vertical (1) est pompée de manière homogène.

2. Dispositif laser à semiconducteur selon la revendication 1, **caractérisé en ce que** le guide d'onde de pompage (9) présente un axe central (10) et la couche quantique (5) est disposée à un écart prédéfini (E) de l'axe central (10) du guide d'onde de pompage (9).

3. Dispositif laser à semiconducteur selon la revendication 1 ou 2, **caractérisé en ce que** le guide d'onde central (3) présente un axe central (12) qui est parallèle à l'axe central (10) du guide d'onde de pompage (9) ou qui coïncide avec l'axe central (10) du guide d'onde de pompage (9).

4. Dispositif laser à semiconducteur selon l'une des revendications 1 à 3, **caractérisé en ce que** la couche quantique (5) présente un écart (E) de l'axe central (10) du guide d'onde de pompage (9) qui est supérieur au rayon de rayonnement du rayonnement de pompage (11) lors de l'entrée dans l'émetteur vertical (1).

5. Dispositif laser à semiconducteur selon la revendication 4, **caractérisé en ce que** le rayonnement de pompage (11) s'élargit à l'intérieur du guide d'onde central (3) et chevauche la couche quantique (5) à un écart prédéfini avant l'entrée du rayonnement de pompage (11) dans l'émetteur vertical (1).

6. Dispositif laser à semiconducteur selon l'une des revendications 1 à 5, **caractérisé en ce que** l'émetteur vertical (1) comprend un miroir (6) qui est disposé à la suite de la structure en pot quantique dans le sens vertical.

7. Dispositif laser à semiconducteur selon la revendication 6, **caractérisé en ce que** la structure en pot quantique est disposée dans le sens vertical entre le miroir (6) et une couche de découplage (7).

8. Dispositif laser à semiconducteur selon la revendication 6 ou 7, **caractérisé en ce qu'**un miroir externe est associé à l'émetteur vertical (1), lequel forme avec le miroir (6) de l'émetteur vertical (1) un résonateur pour le rayonnement (8) émis par la structure en pot quantique.

9. Dispositif laser à semiconducteur selon la revendication 8, **caractérisé en ce qu'**un élément optique non linéaire, de préférence de doublage de la fréquence, est disposé à l'intérieur du résonateur.

10. Dispositif laser à semiconducteur selon la revendication 8 ou 9, **caractérisé en ce qu'**un élément de couplage de mode, notamment un absorbeur semiconducteur saturable, est disposé à l'intérieur du résonateur.

11. Dispositif laser à semiconducteur selon l'une des revendications 8 à 10, **caractérisé en ce qu'**un miroir du résonateur, notamment le miroir externe, est un miroir à dispersion contrôlée pour le rayonnement (8) émis par la structure en pot quantique.

12. Dispositif laser à semiconducteur selon l'une des revendications 6 à 11, **caractérisé en ce que** l'émetteur vertical (1) comprend un miroir de découplage par lequel le rayonnement (8) émis par la structure en pot quantique est découplé.

13. Dispositif laser à semiconducteur selon l'une des revendications 6 à 12, **caractérisé en ce que** le miroir (6) ou les miroirs sont réalisés sous la forme de miroirs de Bragg.

14. Dispositif laser à semiconducteur selon l'une des revendications 1 à 13, **caractérisé en ce que** la source de rayonnement de pompage comprend au moins un laser de pompage (2).

15. Dispositif laser à semiconducteur selon la revendication 14, **caractérisé en ce que** la source de rayonnement de pompage comprend deux lasers de pompage (2) comprenant respectivement un guide d'onde de pompage (9) dont le rayonnement de pompage (11) est injecté en sens inverse dans la structure en pot quantique.

16. Dispositif laser à semiconducteur selon la revendication 14 ou 15, **caractérisé en ce que** la source de rayonnement de pompage comprend une pluralité de lasers de pompage (2) qui sont disposés en forme de cercle ou d'étoile autour de l'émetteur vertical (1).

17. Dispositif laser à semiconducteur selon la revendication 16, **caractérisé en ce que** la source de rayonnement de pompage comprend quatre lasers de pompage (2) qui sont disposés orthogonalement par paires les uns par rapport aux autres.

18. Dispositif laser à semiconducteur selon l'une des revendications 14 à 17, **caractérisé en ce que** le laser de pompage (2) présente un résonateur à laser de pompage et l'émetteur vertical (1) est disposé au moins partiellement à l'intérieur du résonateur à laser de pompage.

19. Dispositif laser à semiconducteur selon l'une des revendications 14 à 18, **caractérisé en ce que** le laser de pompage est réalisé sous la forme d'un laser annulaire.

20. Dispositif laser à semiconducteur selon l'une des revendications 14 à 19, **caractérisé en ce que** le laser de pompage présente un résonateur à laser de pompage ayant une section transversale latérale au moins partiellement trapézoïdale ou doublement trapézoïdale.

21. Dispositif laser à semiconducteur selon l'une des revendications 1 à 20, **caractérisé en ce que** la source de rayonnement de pompage et l'émetteur vertical (1) sont réalisés intégrés monolithiques.

22. Dispositif laser à semiconducteur selon l'une des revendications 1 à 21, **caractérisé en ce que** le dispositif laser à semiconducteur est un laser à disque à semiconducteur.

23. Dispositif laser à semiconducteur selon l'une des revendications 1 à 22, **caractérisé en ce que** le dispositif laser à semiconducteur est configuré pour un fonctionnement pulsé, notamment avec une durée d'impulsions dans la gamme des picosecondes ou des femtosecondes.

24. Dispositif laser à semiconducteur selon l'une des revendications 1 à 23, **caractérisé en ce que** lors du fonctionnement de l'émetteur vertical (1), la structure en pot quantique génère un champ de rayonnement qui forme une onde stationnaire, la couche quantique (5) étant disposée de telle sorte qu'elle chevauche un ventre d'onde de l'onde stationnaire.
